# EUROPEAN PATENT APPLICATION

(11) **EP 1 608 009 A1**
(43) Date of publication of application: **21.12.2005**
(21) Application number: 04707668.2
(22) Date of filing: 03.02.2004
(51) Int. Cl.: H01L 21/60, H01L 21/82, H01L 27/04, H01L 27/10

(54) **SEMICONDUCTOR DEVICE**

(30) Priority: 19.02.2003 JP 2003040730
(71) Applicant: SONY CORPORATION, Tokyo 141-0001 (JP)
(72) Inventor: EZAKI, Takayuki, (JP)
(74) Representative: Thévenet, Jean-Bruno
(86) International application number: PCT/JP2004/001079
(87) International publication number: WO 2004/075280

(57) **Abstract**

When performing connection to an external substrate by heat pressure, damage to a first functional area having low resistance against an applied pressure is alleviated, and to carried out the connection with high reliability.

The present invention is such that a semiconductor device has, on a substrate (10), a first functional area (1) (for example, a storage element area) and a second functional area (2) (for example, a driving circuit or signal processing circuit), wherein, if the substrate (10) is viewed in a planar fashion, a bump corresponding to an electrode for externally inputting and outputting a signal is provided in the second functional area (2) disposed inside a circumscribed rectangle of the first functional area (1).

## Description

### Technical Field

The present invention relates to a semiconductor device including, on a substrate, a first functional area including a storage area and the like, a second functional area including a driving circuit and the like, and an electrode for externally inputting and outputting a signal.

### Background Art

As a technique of connecting a chip (a DRAM chip), on which a memory such as a DRAM (Dynamic Random Access Memory), a driving circuit and the like are formed, to an external substrate, a method of fixing the chip onto the external substrate through hot pressing using a solder bump is known. In the case where a bump connection pad is disposed on the DRAM chip, a load is applied to a DRAM cell array at the time of a bump connection (assembling) if the bump connection pad is provided immediately above the DRAM cell array. Therefore, there arises a problem that the DRAM cell array is damaged, the characteristics of the DRAM cell array are degraded, or the like.

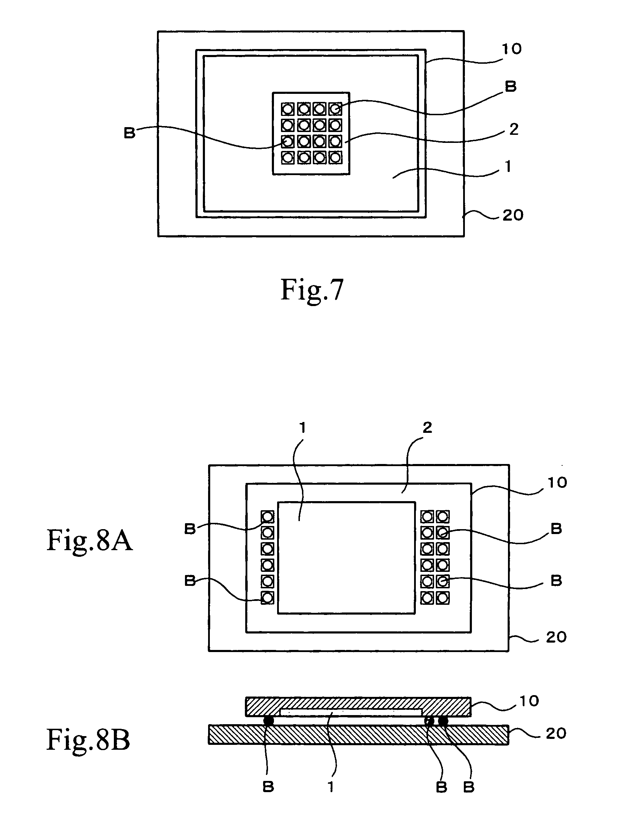

Therefore, the bump connection pad is conventionally disposed at the position of a peripheral circuit (the driving circuit or the like) so as not to be situated immediately above the DRAM cell array. Figs. 8A and 8B are schematic views illustrating a conventional semiconductor device, where Fig. 8A is a plan view and Fig. 8B is a sectional view. Specifically, the semiconductor device has such a structure that a substrate 10 including a DRAM chip and the like is connected to an external substrate 20 including an LSI such as a signal processing chip through bumps B. In this case, bump connection pads and the bumps B are disposed in a second functional area 2 where the other signal processing circuits and the like are formed, so as to avoid the same surface of a DRAM cell array area (a first functional area 1) formed on the DRAM chip. Moreover, a technique related to the arrangement of a bonding pad for connecting a bonding wire is disclosed in Patent Document 1.

Patent Document 1: Japanese Patent Application Publication No. Hei 4-162664

In the conventional semiconductor device, the bump connection pads and the bumps are disposed so as to avoid the DRAM cell array area. Therefore, the DRAM cell array is not affected even if a load is applied through the bumps at the connection of the DRAM chip. However, since the bump connection pads and the bumps are disposed so as to be separated from each other, for example, at both ends on the DRAM chip, there arises a problem that a yield at the time of the bump connection (assembling) is lowered. Specifically, even a slight inclination of the DRAM chip causes a variation in load applied to the bumps provided at both horizontal ends. Uniform pressure connection for all the bumps becomes difficult, for example, a bump at one end is successfully connected whereas a bump at the other end is not fully seated, resulting in lowered reliability of products.

### Disclosure of the Invention

The present invention is devised to solve the above problems. Specifically, in the present invention, a semiconductor device including a first functional area and a second functional area, which are provided on a substrate, wherein an electrode for externally inputting and outputting a signal is provided so as to overlap the second functional area provided inside a circumscribed rectangle of the first functional area when the substrate is viewed in a planar fashion.

In the present invention described above, the electrodes are provided so as to overlap the second functional area provided inside the circumscribed rectangle of the first functional area. Therefore, the electrodes are collectively arranged in approximately the center of the substrate. As a result, a pressure can be prevented from being applied to the first functional area upon connection. At the same time, pressure connection to an external substrate through the electrodes can be achieved without expanding the area where the electrodes are arranged. Thus, uniform connection to the electrodes can be achieved.

### Brief Description of Drawings

Figs. 1A and 1B are schematic views for illustrating a semiconductor device according to a first embodiment;
Figs. 2A and 2B are schematic views for illustrating a semiconductor device according to a second embodiment;
Fig. 3 is a schematic plan view for illustrating a semiconductor device according to a third embodiment;
Fig. 4 is a schematic plan view for illustrating a semiconductor device according to a fourth embodiment;
Fig. 5 is a schematic plan view for illustrating a semiconductor device according to a fifth embodiment;
Fig. 6 is a schematic plan view for illustrating a semiconductor device according to a sixth embodiment;
Fig. 7 is a schematic plan view for illustrating a semiconductor device according to a seventh embodiment; and
Figs. 8A and 8B are schematic views for illustrating a conventional semiconductor device.

### Best Mode for Carrying Out the Invention

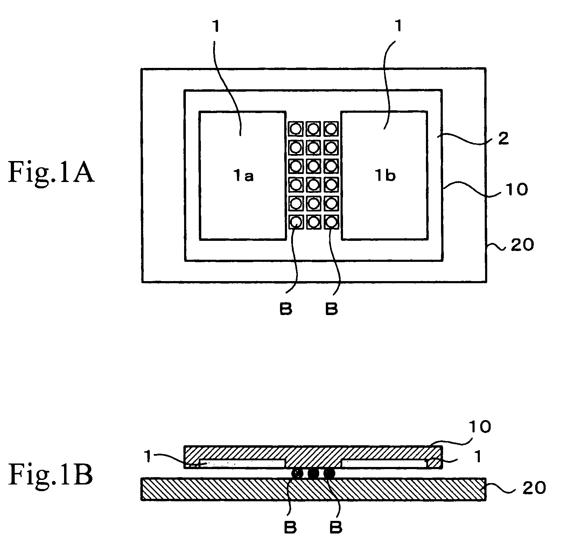

Hereinafter, embodiments of the present invention will be described based on the drawings. Figs. 1A and 1B are schematic views for illustrating a semiconductor device according to a first embodiment, where Fig. 1A is a plan view and Fig. 1B is a sectional view. Specifically, the semiconductor device includes first functional areas 1 and a second functional area 2 provided on a chip-like substrate 10. The first functional area 1 serves as a DRAM cell array (a storage element area), whereas the second functional area 2 serves as a signal processing circuit or a driving circuit for the DRAM cell array .

The semiconductor device according to the first embodiment has two first functional areas (1a and 1b). Bumps (metal projections) B for externally inputting and outputting a signal are provided in the second functional area 2, which is an area between the first functional areas (an inner area of a circumscribed rectangle when the first functional areas 1 are viewed in a planar fashion). The semiconductor device is connected face-down to an external substrate 20 through the bumps B.

By the above-mentioned arrangement of each of the components, the bumps B can be provided in approximately the center of the substrate 10 so as not to be situated directly above the DRAM cell arrays corresponding to the first functional areas 1. Therefore, at heat pressure connection of the semiconductor device to the external substrate 20 through the bumps B, a pressure is not applied from the bumps B to the DRAM cell arrays (the first functional areas 1).

Specifically, the DRAM cell arrays corresponding to the first functional areas 1 have lower resistance against the applied pressure per given area (hereinafter, referred to simply as "resistance against the applied pressure") than that of the area of the signal processing circuit or the driving circuit corresponding to the second functional area 2. Therefore, a pressure is not applied from the bumps B to the DRAM cell arrays (the first functional areas 1), thereby making possible to prevent the DRAM cell arrays from being damaged.

Moreover, since the bumps B are disposed in approximately the center of the substrate 10, a distance between the bumps at both extremities can be reduced as compared with the case where the bumps are provided at the ends of the substrate 10, and even if the substrate 10 is inclined to some degree, uniform bump connection to the external substrate 20 can be achieved.

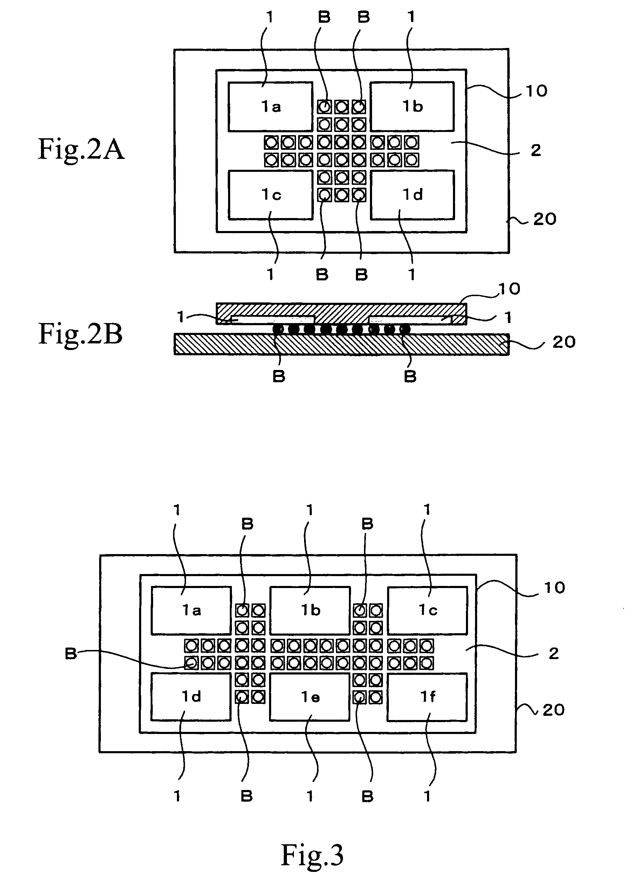

Figs. 2A and 2B are schematic views for illustrating a semiconductor device according to a second embodiment, where Fig. 2A is a plan view and Fig. 2B is a sectional view. Specifically, the semiconductor device includes the first functional areas 1 and the second functional area 2 provided on the chip-like substrate 10. As the first functional areas 1, four functional areas 1 (1a, 1b, 1c and 1d) are provided. The plurality of bumps B are provided in a cross-like pattern in the second functional area 2, which is an area between the first functional areas (an inner area of a circumscribed rectangle when the first functional areas 1 are viewed in a planar fashion). The semiconductor device is connected face-down to the external substrate 20 through the bumps B.

By the above-mentioned arrangement of each of the components, the bumps B can be provided in approximately the center of the substrate 10 so as not to be situated directly above the DRAM cell arrays corresponding to the first functional areas 1. Therefore, at heat pressure connection of the semiconductor device to the external substrate 20 through the bumps B, the same functional effects as those in the previously described example are obtained. Specifically, a pressure is not applied from the bumps B to the DRAM cell arrays (the first functional areas 1) which have lower resistance against the applied pressure (lower resistance against the applied pressure than that of the area of the signal processing circuit or the driving circuit corresponding to the second functional area 2). Therefore, the DRAM cell arrays can be prevented from being damaged.

Moreover, the plurality of bumps B are arranged in a cross-like pattern. As a result, the bumps can be arranged in approximately the center of the substrate 10. At the same time, a wiring distance between each of the bumps B and the first functional area 1 can be reduced as much as possible, so that a signal delay can be prevented.

Fig. 3 is a schematic plan view for illustrating a semiconductor device according to a third embodiment. The semiconductor device is an example of application of the semiconductor device shown in Figs. 2A and 2B according to the second embodiment, and includes the first functional areas 1 and the second functional area 2 provided on the chip-like substrate 10. As the first functional areas 1, six functional areas 1 (1a, 1b, 1c, 1d, 1e and 1f) are provided. The plurality of bumps B are provided in a contiguous cross-like pattern in the second functional area 2, which is an area between the first functional areas 1 (an inner area of a circumscribed rectangle when the first functional areas 1 are viewed in a planar fashion).

As described above, any number of the first functional areas 1 may be provided. The bumps B are provided at the position in the second functional area 2, which is an area between the first functional areas (for example, 1a to 1f). As a result, the arrangement of the bumps in approximately the center of the substrate 10 and the reduction of the wiring distance between each of the bumps B and the first functional areas 1 can be achieved at the same time.

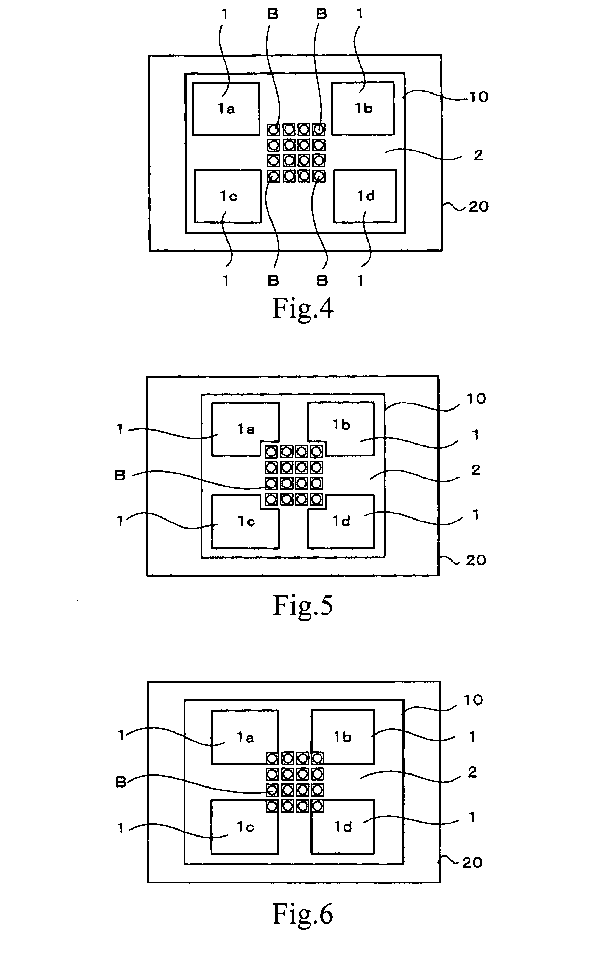

Fig. 4 is a schematic plan view for illustrating a semiconductor device according to a fourth embodiment. The semiconductor device is an example of application of the semiconductor device shown in Fig. 2 according to the second embodiment, and includes the first functional areas 1 and the second functional area 2 provided on the chip-like substrate 10. As the first functional areas 1, four functional areas 1 (1a, 1b, 1c and 1d) are provided. The plurality of bumps B are provided in a rectangular pattern in the second functional area 2, which is an area between the first functional areas (an inner area of a circumscribed rectangle when the first functional areas 1 are viewed in a planar fashion).

As a result of the arrangement of each of the components as described above, the bumps can be arranged in approximately the center of the substrate 10 while the reduction of the wiring distance between each of the bumps B and the first functional areas 1 can be made possible.

Fig. 5 is a schematic plan view for illustrating a semiconductor device according to a fifth embodiment. The semiconductor device is an example of application of the semiconductor device shown in Fig. 4 according to the fourth embodiment, and includes the first functional areas 1 and the second functional area 2 provided on the chip-like substrate 10. As the first functional areas 1, four functional areas 1 (1a, 1b, 1c and 1d) are provided. The plurality of bumps B are provided in a rectangular pattern in the second functional area 2, which is an area between the first functional areas (an inner area of a circumscribed rectangle when the first functional areas 1 are viewed in a planar fashion).

In this embodiment, the first functional areas 1 (1a to 1d), each being cut, are arranged so as to surround the bumps B arranged in approximately the center of the substrate 10 in a rectangular pattern. As a result of such arrangement, the bumps can be arranged in approximately the center of the substrate 10 while the reduction of the wiring distance between each of the bumps B and the first functional areas 1 can be made possible. At the same time, layout efficiency of the substrate 10 can be enhanced.

Fig. 6 is a schematic plan view for illustrating a semiconductor device according to a sixth embodiment. The semiconductor device is an example of application of the semiconductor device shown in Fig. 5 according to the fifth embodiment, and includes the first functional areas 1 and the second functional area 2 provided on the chip-like substrate 10. As the first functional areas 1, four functional areas 1 (1a, 1b, 1c and 1d) are provided. The plurality of bumps B are provided in a rectangular pattern in the second functional area 2, which is an area between the first functional areas (an inner area of a circumscribed rectangle when the first functional areas 1 are viewed in a planar fashion).

This embodiment particularly differs from the other embodiments in that the corners of the bumps B partially overlap the first functional areas 1. Specifically, it is apparent that an overlap part of the first functional areas 1 with the bumps B is subjected to a pressure upon connection. Therefore, from the very beginning of design, a part of the first functional areas 1, which is pressurized by the bumps B, is set as an invalid area (a non-functioning area) in advance. As a result, the area of the bumps B and the first functional areas 1 can come closer to each other. Therefore, in addition to the effects of the semiconductor device according the fifth embodiment, layout efficiency can also be enhanced.

Fig. 7 is a schematic plan view for illustrating a semiconductor device according to a seventh embodiment. The semiconductor device is arranged so that the second functional area 2 is surrounded by the first functional area 1. The bumps B are arranged in the second functional area 2 surrounded by the first functional area 1. Specifically, the first functional area 1 has a continuous annular pattern. In a space in the middle of the first functional area, the second functional area 2 and the bumps B are arranged.

Even if the first functional area 1 is annular without being divided as described above, the bumps B can be arranged in approximately the center of the substrate 10. Moreover, the wiring distance between each of the bumps B and the first functional area 1 can be reduced.

It should be noted that, in each of the embodiments described above, the plurality of first functional areas 1 may be obtained by dividing a single functional area to be arranged or arranging a plurality of functional areas. For example, if the first functional area 1 is composed of a DRAM cell array, the DRAM cell array may be divided into a plurality of DRAM cell arrays to be arranged so as to achieve 256 Mbit in total (in this case, a single DRAM cell array obtained by the division corresponds to one first functional area 1). Alternatively, a plurality of DRAM cell arrays, each being a 256-Mbit DRAM cell array serving as a single first functional area 1, may be arranged (in this case, a total capacity is obtained by: the number of first functional areas 1 × 256 Mbit).

Although a rectangle shape has been mainly described as the shape of the first functional area 1, it is not limited thereto. The first functional area may include a curve area such as a circle. Furthermore, the same effects can be achieved if an electrode other than the bump B is used as long as it allows connection by the heat pressure.

### Industrial Applicability

As described above, according to the present invention, the following effects are obtained. Specifically, if the semiconductor device is to be connected to the external substrate by the heat pressure, a pressure through the electrodes is no longer applied to the first functional area, so that and the first functional area is prevented from being damaged. Furthermore, since the arrangement of the electrodes concentrates in approximately the center of the substrate, uniform connection to the electrodes provides a highly reliable apparatus.

## Claims

1. A semiconductor device having, on a substrate, a first functional area and a second functional area, **characterized in that**:
if the substrate is viewed in a planar fashion, an electrode for externally inputting and outputting a signal is provided in the second functional area disposed inside a circumscribed rectangle of the first functional area.

2. The semiconductor device according to claim 1, **characterized in that**:
resistance against an applied pressure of the second functional area is larger than resistance against an applied pressure of the first functional area.

3. The semiconductor device according to claim 1, **characterized in that**:
the electrode has a bump.

4. The semiconductor device according to claim 1, **characterized in that**:
the first functional area has a storage element, and the second functional area has a signal processing circuit or a driving circuit.

5. The semiconductor device according to claim 1, **characterized in that**:
the plurality of first functional areas are exist, and the electrodes are disposed between each of the first functional areas.

6. The semiconductor device according to claim 5, **characterized in that**:
twoormore first functional areas are exist in lengthwise and crosswise directions.

7. The semiconductor device according to claim 1, **characterized in that**:
the second functional area is disposed in a state of being surrounded by the first functional area, and the electrode is disposed in the second functional area surrounded by the first functional area.
